(19) Europäisches Patentamt
European Patent Office
Office européen des brevets

(11) **EP 4 119 955 B1**

(12) **EUROPEAN PATENT SPECIFICATION**

(45) Date of publication and mention
of the grant of the patent:
**17.01.2024 Bulletin 2024/03**

(21) Application number: **20928333.2**

(22) Date of filing: **03.04.2020**

(51) International Patent Classification (IPC):
*G01B 7/02* $^{(2006.01)}$       *G01R 31/58* $^{(2020.01)}$
*H04B 3/46* $^{(2015.01)}$

(52) Cooperative Patent Classification (CPC):
**G01R 31/58; G01B 7/02; H04B 3/46**

(86) International application number:
**PCT/JP2020/015344**

(87) International publication number:
**WO 2021/199432 (07.10.2021 Gazette 2021/40)**

(54) **TRANSMISSION LINE LENGTH DETECTION DEVICE AND NETWORK COMMUNICATION DEVICE**

VORRICHTUNG ZUR ERKENNUNG DER ÜBERTRAGUNGSLINIENLÄNGE UND
NETZWERKKOMMUNIKATIONSVORRICHTUNG

DISPOSITIF DE DÉTECTION DE LONGUEUR DE LIGNE DE TRANSMISSION ET DISPOSITIF DE
COMMUNICATION DE RÉSEAU

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**18.01.2023 Bulletin 2023/03**

(73) Proprietor: **MITSUBISHI ELECTRIC
CORPORATION
Chiyoda-ku
Tokyo 100-8310 (JP)**

(72) Inventors:
• **ITAKURA, Hiroshi
Tokyo 100-8310 (JP)**
• **AKEBOSHI, Yoshihiro
Tokyo 100-8310 (JP)**

(74) Representative: **Pfenning, Meinig & Partner mbB
Patent- und Rechtsanwälte
Theresienhöhe 11a
80339 München (DE)**

(56) References cited:
WO-A1-2019/043828       JP-A- H1 164 412
JP-A- H07 201 419       JP-A- 2004 064 754
JP-A- 2006 017 606       JP-A- 2007 163 237
JP-A- 2013 185 978       US-A1- 2003 128 039
US-A1- 2011 012 608       US-A1- 2017 146 332

**Description**

## TECHNICAL FIELD

The present disclosure relates to a transmission line length detection device that calculates the electric length of a transmission line, and a network communication device that includes the transmission line length detection device.

## BACKGROUND ART

There are cases in which an existing communication network is used as a communication network which is used for transmission and reception of signals by a network communication device. The transmission speed of a signal to be transmitted and received by the network communication device may be determined in such a way as to fall within a range in which the communication network can be handled as a lumped constant line. In order to determine the transmission speed, it is necessary to measure the electric length of the transmission line.

As a method of measuring the electric length of a transmission line, a time domain reflectometry (TDR) method is known (refer to Patent Literature 1). The TDR method is the one for giving a step wave to one end of a transmission line which is an object to be measured, thereby observing a reflected wave of the step wave reflected by the other end of the transmission line at the one end of the transmission line, and calculating the electric length of the transmission line on the basis of the time elapsed until the reflected wave is observed since the step wave has been given.

Patent Literature 2 shows a transmission line length detection device comprising a first capacitance calculating unit configured to calculate a total capacitance of the transmission line based on a measured voltage change and an electric length calculation unit configured to calculate an electric length of the transmission line by dividing the total capacitance by a known value of the capacitance per unit length.

## CITATION LIST

### PATENT LITERATURE

Patent Literature 1: JP 2013-024729 A
Patent Literature 2: US 2017/0146332 A1

## SUMMARY OF INVENTION

### TECHNICAL PROBLEM

If there is no branch point in a transmission line of an existing communication network, and the communication network is constituted by a single transmission line, it is possible to calculate the electric length of the transmission line by using the TDR method. However, in a case where the communication network has branches in the middle of the line, and therefore multiple reflected waves occur because of the reflection of a step wave at each of multiple line ends, it is difficult to specify a reflected wave which is an object to be observed, and which can be used for the calculation of the electric length. Therefore, a problem is that in the case where the communication network has branches in the middle of the line, the TDR method does not make it possible to measure the electric length of the transmission line.

The present disclosure is made in order to solve the above-mentioned problem, and it is therefore an object of the present disclosure to provide a transmission line length detection device that can measure the electric length of a transmission line regardless of whether a communication network has branches in the middle of the line.

### SOLUTION TO PROBLEM

A transmission line length detection device according to the present disclosure includes: a first capacitance calculation unit to observe a voltage change in a transmission line in a communication network, and to calculate the total capacitance which is the capacitance of the whole of the transmission line on the basis of the voltage change; a second capacitance calculation unit to measure the characteristic impedance of the transmission line and to calculate the capacitance per unit length of the transmission line from the characteristic impedance; and an electric length calculation unit to calculate the electric length of the transmission line by dividing the total capacitance calculated by the first capacitance calculation unit by the capacitance per unit length calculated by the second capacitance calculation unit.

ADVANTAGEOUS EFFECTS OF INVENTION

According to the present disclosure, it is possible to measure the electric length of the transmission line regardless of whether the communication network has branches in the middle of the line.

**BRIEF DESCRIPTION OF DRAWINGS**

FIG. 1 is a schematic diagram showing a communication system including a transmission line length detection device 3 according to Embodiment 1;
FIG. 2 is a hardware block diagram showing the hardware of a part of the transmission line length detection device 3 according to Embodiment 1;
FIG. 3 is a hardware block diagram of a computer in a case where the part of transmission line length detection device 3 is implemented by software or firmware;
FIG. 4 is a flowchart showing the processing procedures performed by the part of the transmission line length detection device 3;
FIG. 5 is an explanatory drawing showing a change in a voltage V at a supply point of a constant current $I_0$;
FIG. 6 is an explanatory drawing showing a change in a voltage V' at a supply point of a step signal;
FIG. 7 is an explanatory drawing showing a change in the voltage V at the supply point of the constant current $I_0$;
FIG. 8 is a schematic diagram showing another communication system including the transmission line length detection device 3 according to Embodiment 1;
FIG. 9 is a schematic diagram showing a communication system including a transmission line length detection device 3 according to Embodiment 2;
FIG. 10 is a hardware block diagram showing the hardware of a part of the transmission line length detection device 3 according to Embodiment 2;
FIG. 11 is a schematic diagram showing a communication system including a transmission line length detection device 3 according to Embodiment 3; and
FIG. 12 is a hardware block diagram showing the hardware of a part of the transmission line length detection device 3 according to Embodiment 3.

**DESCRIPTION OF EMBODIMENTS**

Hereinafter, in order to explain the present disclosure in greater detail, embodiments of the present disclosure will be explained with reference to the accompanying drawings.

Embodiment 1.

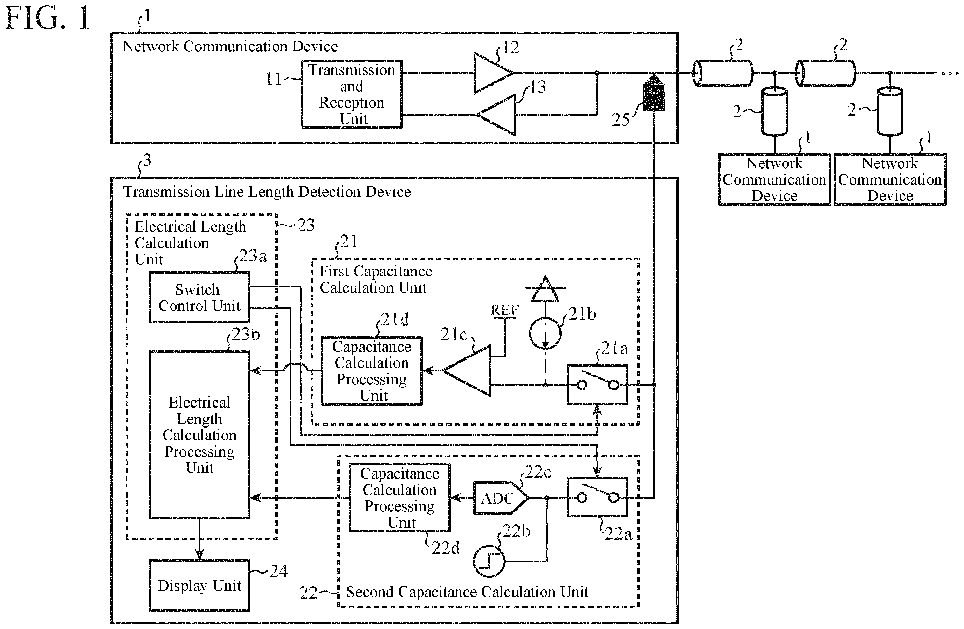

FIG. 1 is a schematic diagram showing a communication system including a transmission line length detection device 3 according to Embodiment 1.
The communication system shown in FIG. 1 includes network communication devices 1, a transmission line 2 and the transmission line length detection device 3.
In the communication system shown in FIG. 1, the multiple network communication devices 1 are connected to the transmission line 2. A communication network is formed by the multiple network communication devices 1 and the transmission line 2.
In the communication system shown in FIG. 1, each of the multiple network communication devices 1 is connected to a line end of the transmission line 2. However, this is only an example, and there is no particular limit to the positions of connection of the network communication devices 1 to the transmission line 2.
The communication network may be a bus-type network, a star-type network or the like, or may be a single transmission line without any branch. However, the communication network is an existing one, and the line length of the transmission line 2 and the connection configuration of the transmission line 2 are unknown.
Each network communication device 1 includes a transmission and reception unit 11, a driver integrated circuit (IC) 12 and a receiver IC 13.
The transmission and reception unit 11 outputs a transmission signal to the transmission line 2 via the driver IC 12.
The transmission and reception unit 11 receives a signal transmitted through the transmission line 2 via the receiver IC 13.
The driver IC 12 outputs the transmission signal outputted from the transmission and reception unit 11 to the transmission line 2.

The receiver IC 13 receives the signal transmitted through the transmission line 2, and outputs this signal to the transmission and reception unit 11.

The transmission line length detection device 3 includes a first capacitance calculation unit 21, a second capacitance calculation unit 22, an electric length calculation unit 23 and a display unit 24.

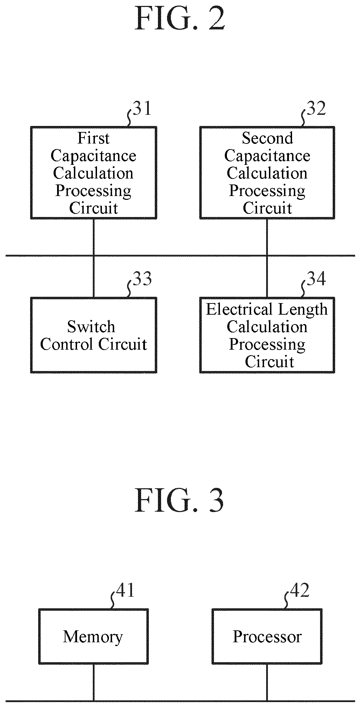

FIG. 2 is a hardware block diagram showing the hardware of a part of the transmission line length detection device 3 according to Embodiment 1.

The first capacitance calculation unit 21 includes a switch 21a, a constant current source 21b, a voltage reference circuit 21c and a capacitance calculation processing unit 21d.

The first capacitance calculation unit 21 observes a voltage change in the transmission line 2 in the communication network, and calculates the total capacitance $C_{total}$ which is the capacitance of the whole of the transmission line 2 on the basis of the voltage change.

More specifically, the first capacitance calculation unit 21 observes a voltage change at the supply point of a constant current $I_0$ to the transmission line 2 when the constant current $I_0$ is supplied to the transmission line 2, and calculates the total capacitance $C_{total}$ of the transmission line 2 from the voltage change.

The first capacitance calculation unit 21 outputs first capacitance information showing the total capacitance $C_{total}$ to the electric length calculation unit 23.

One end of the switch 21a is connected to a probe 25 which will be mentioned later, and the other end of the switch 21a is connected to each of the following components: the constant current source 21b and the voltage reference circuit 21c.

When a control signal outputted from a switch control unit 23a, which will be mentioned later, of the electric length calculation unit 23 shows an ON command, the switch 21a enters a closed state.

When the control signal outputted from the switch control unit 23a shows an OFF command, the switch 21a enters an open state.

The constant current source 21b supplies the constant current $I_0$ to the transmission line 2 via the switch 21a and the probe 25.

The voltage reference circuit 21c observes a voltage change at the supply point of the constant current $I_0$ to the transmission line 2 while the constant current $I_0$ is outputted from the constant current source 21b.

The voltage reference circuit 21c measures a time $\Delta t$ required for the voltage V at the supply point of the constant current $I_0$ to vary from 0 [V] to a reference voltage REF [V], and outputs the time $\Delta t$ to the capacitance calculation processing unit 21d.

The capacitance calculation processing unit 21d is implemented by, for example, a first capacitance calculation processing circuit 31 shown in FIG. 2.

The capacitance calculation processing unit 21d calculates the total capacitance $C_{total}$ by multiplying the constant current $I_0$, which is a known value, and the time $\Delta t$ together, and dividing the result of the multiplication of the constant current $I_0$ and the time $\Delta t$ by the reference voltage REF.

The capacitance calculation processing unit 21d outputs the first capacitance information showing the total capacitance $C_{total}$ to an electric length calculation processing unit 23b, which will be mentioned later, of the electric length calculation unit 23.

The second capacitance calculation unit 22 includes a switch 22a, a step signal source 22b, an analog to digital converter (referred to as the "ADC" hereinafter) 22c and a capacitance calculation processing unit 22d.

One end of the switch 22a is connected to the probe 25, and the other end of the switch 22a is connected to each of the following components: the step signal source 22b and the ADC 22c.

When a control signal outputted from the switch control unit 23a shows an ON command, the switch 22a enters a closed state.

When the control signal outputted from the switch control unit 23a shows an OFF command, the switch 22a enters an open state.

The step signal source 22b supplies a step signal to the transmission line 2 via the switch 22a and the probe 25. The step signal is a signal whose signal level steeply varies from 0 to 1.

By supplying a step signal from the step signal source 22b to the transmission line 2, either a reflected wave of the step signal reflected by a branch point of the transmission line 2 or a reflected wave of the step signal reflected by a line end of the transmission line 2 returns to the supply point of the step signal to the transmission line 2.

The ADC 22c converts the voltage of the step signal at the supply point from an analog signal to a digital signal.

The ADC 22c outputs the digital signal to the capacitance calculation processing unit 22d.

The capacitance calculation processing unit 22d is implemented by, for example, a second capacitance calculation processing circuit 32 shown in FIG. 2.

The capacitance calculation processing unit 22d determines the characteristic impedance $Z_0$ of the transmission line 2 on the basis of the digital signal outputted from the ADC 22c.

The capacitance calculation processing unit 22d calculates the capacitance per unit length $C_{UL}$ of the transmission line 2 from the characteristic impedance $Z_0$.

The capacitance calculation processing unit 22d outputs second capacitance information showing the capacitance per unit length $C_{UL}$ to the electric length calculation processing unit 23b of the electric length calculation unit 23.

The electric length calculation unit 23 includes the switch control unit 23a and the electric length calculation processing unit 23b.

The electric length calculation unit 23 calculates the electric length $E_L$ of the transmission line 2 by dividing the total capacitance $C_{total}$ calculated by the first capacitance calculation unit 21 by the capacitance per unit length $C_{UL}$ calculated by the second capacitance calculation unit 22.

The switch control unit 23a is implemented by, for example, a switch control circuit 33 shown in FIG. 2.

The switch control unit 23a outputs either a control signal showing an ON command or a control signal showing an OFF command to the switch 21a.

The switch control unit 23a also outputs either a control signal showing an ON command or a control signal showing an OFF command to the switch 22a.

The electric length calculation processing unit 23b is implemented by, for example, an electric length calculation processing circuit 34 shown in FIG. 2.

The electric length calculation processing unit 23b calculates the electric length $E_L$ of the transmission line 2 by dividing the total capacitance $C_{total}$ shown by the first capacitance information outputted from the capacitance calculation processing unit 21d by the capacitance per unit length $C_{UL}$ shown by the second capacitance information outputted from the capacitance calculation processing unit 22d.

The electric length calculation processing unit 23b outputs a display signal for causing the display unit 24 to display the electric length $E_L$ of the transmission line 2 to the display unit 24.

The display unit 24 is implemented by, for example, a liquid crystal display.

The display unit 24 displays the electric length $E_L$ of the transmission line 2 in accordance with the display signal outputted from the electric length calculation processing unit 23b.

The probe 25 is an instrument for supplying either the constant current $I_0$ outputted from the constant current source 21b or the step signal outputted from the step signal source 22b to the transmission line 2.

In FIG. 1, it is assumed that each of the following units: the capacitance calculation processing unit 21d, the capacitance calculation processing unit 22d, the switch control unit 23a and the electric length calculation processing unit 23b, which are components of the part of the transmission line length detection device 3, is implemented by hardware for exclusive use as shown in FIG. 2. More specifically, it is assumed that the part of the transmission line length detection device 3 is implemented by the first capacitance calculation processing circuit 31, the second capacitance calculation processing circuit 32, the switch control circuit 33 and the electric length calculation processing circuit 34.

Each of the following circuits: the first capacitance calculation processing circuit 31, the second capacitance calculation processing circuit 32, the switch control circuit 33 and the electric length calculation processing circuit 34 is, for example, a single circuit, a composite circuit, a programmable processor, a parallel programmable processor, an application specific integrated circuit (ASIC), a field-programmable gate array (FPGA), or a combination of these circuits.

Each of the components of the part of the transmission line length detection device 3 is not limited to what is implemented by hardware for exclusive use, and the part of the transmission line length detection device 3 may be implemented by software, firmware, or a combination of software and firmware.

The software or the firmware is stored as a program in a memory of a computer. The computer refers to hardware that executes a program, and is, for example, a central processing unit (CPU), a central processing device, a processing device, an arithmetic device, a microprocessor, a microcomputer, a processor, or a digital signal processor (DSP).

FIG. 3 is a hardware block diagram of the computer in a case where the part of the transmission line length detection device 3 is implemented by software, firmware or the like.

In the case where the part of the transmission line length detection device 3 is implemented by software, firmware or the like, a program for causing the computer to perform each of the processing procedures performed by the capacitance calculation processing unit 21d, the capacitance calculation processing unit 22d, the switch control unit 23a and the electric length calculation processing unit 23b is stored in a memory 41. A processor 42 of the computer then executes the program stored in the memory 41.

Next, the operation of the communication system shown in FIG. 1 will be explained.

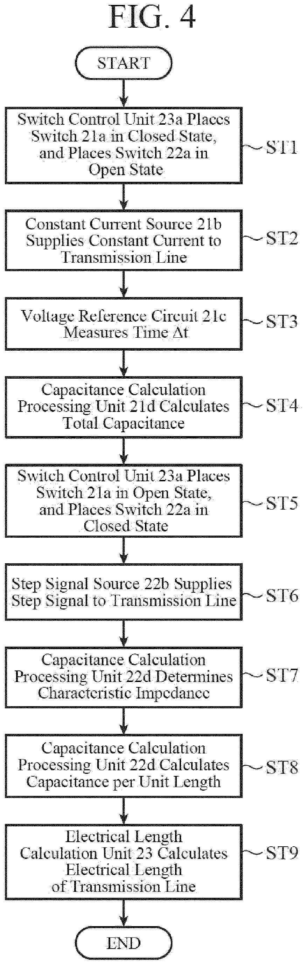

FIG. 4 is a flowchart showing the processing procedures performed by the part of the transmission line length detection device 3.

First, the switch control unit 23a places the switch 21a in the closed state by outputting a control signal showing the ON command to the switch 21a (step ST1 of FIG. 4).

The switch control unit 23a also places the switch 22a in the open state by outputting a control signal showing the OFF command to the switch 22a (step ST1 of FIG. 4).

The constant current source 21b supplies the constant current $I_0$ to the transmission line 2 via the switch 21a and the probe 25 (step ST2 of FIG. 4).

The voltage reference circuit 21c observes a voltage change at the supply point of the constant current $I_0$ to the transmission line 2 while the constant current $I_0$ is outputted from the constant current source 21b.

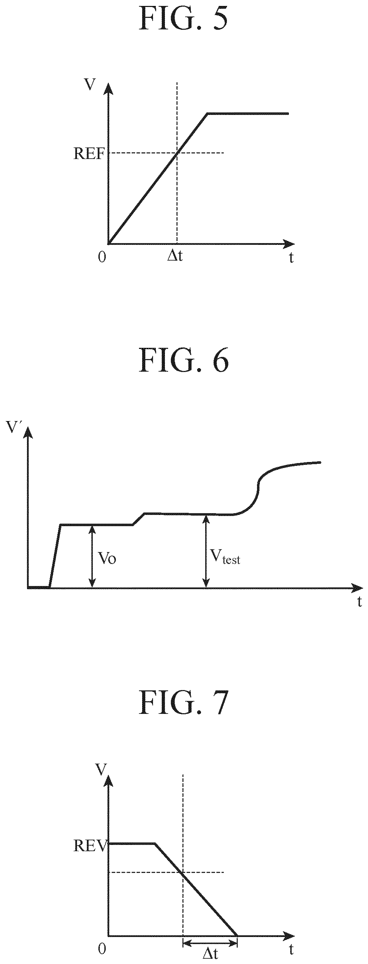

The supply point of the constant current $I_0$ to the transmission line 2 is the installation point of the probe 25. When the supply of the constant current $I_0$ is started, the voltage V at the supply point of the constant current $I_0$ rises monotonously with time from 0 [V], as shown in FIG. 5. The voltage V becomes higher than the reference voltage REF [V], and, after that, becomes a certain voltage.

FIG. 5 is an explanatory drawing showing a change in the voltage V at the supply point of the constant current $I_0$.

The voltage reference circuit 21c measures the time $\Delta t$ required for the voltage V at the supply point of the constant current $I_0$ to vary from 0 [V] to the reference voltage REF [V] (step ST3 of FIG. 4).

The voltage reference circuit 21c outputs the time $\Delta t$ to the capacitance calculation processing unit 21d.

When receiving the time $\Delta t$ from the voltage reference circuit 21c, the capacitance calculation processing unit 21d calculates the total capacitance $C_{total}$ [F] by multiplying the constant current $I_0$, which is a known value, and the time $\Delta t$ together, and dividing the result of the multiplication of the constant current $I_0$ and the time $\Delta t$ by the reference voltage REF [V] (step ST4 of FIG. 4), as shown in the following equation (1).

$$C_{total} = \frac{I_0 \times \Delta t}{REF} \qquad (1)$$

The capacitance calculation processing unit 21d outputs the first capacitance information showing the total capacitance $C_{total}$ to the electric length calculation processing unit 23b.

The switch control unit 23a places the switch 21a in the open state by outputting a control signal showing the OFF command to the switch 21a (step ST5 of FIG. 4).

The switch control unit 23a also places the switch 22a in the closed state by outputting a control signal showing the ON command to the switch 22a (step ST5 of FIG. 4).

The step signal source 22b supplies a step signal to the transmission line 2 via the switch 22a and the probe 25 (step ST6 of FIG. 4).

By supplying a step signal from the step signal source 22b to the transmission line 2, either a reflected wave of the step signal reflected by a branch point of the transmission line 2 or a reflected wave of the step signal reflected by a line end of the transmission line 2 returns to the supply point of the step signal to the transmission line 2. The supply point of the step signal to the transmission line 2 is the installation point of the probe 25.

The voltage V' at the supply point of the step signal varies with time, as shown in FIG. 6.

FIG. 6 is an explanatory drawing showing a change in the voltage V' at the supply point of the step signal.

Until the reflected wave of the step signal reflected by a branch point of the transmission line 2 returns to the supply point of the step signal after the step signal has been supplied from the step signal source 22b to the transmission line 2, the voltage V' remains $V_0$.

When the reflected wave of the step signal reflected by a branch point of the transmission line 2 returns to the supply point of the step signal, the voltage V' rises from $V_0$ to $V_{test}$.

Further, in a case where the line end of the transmission line 2 is an open end, when the reflected wave of the step signal reflected by the open end returns to the supply point of the step signal, the voltage V' rises from $V_{test}$ to $2 \times V_0$.

The ADC 22c converts the voltage V' at the supply point of the step signal from an analog signal to a digital signal.

The ADC 22c outputs the digital signal to the capacitance calculation processing unit 22d.

The capacitance calculation processing unit 22d determines the characteristic impedance $Z_0$ [Ω] of the transmission line 2 on the basis of the digital signal outputted from the ADC 22c (step ST7 of FIG. 4).

Hereinafter, the process of determining the characteristic impedance $Z_0$ by the capacitance calculation processing unit 22d will be explained concretely.

The capacitance calculation processing unit 22d determines the voltage $V_0$ when the step signal is supplied to the transmission line 2, by observing the waveform of the digital signal outputted from the ADC 22c. More specifically, the capacitance calculation processing unit 22d determines the voltage $V_0$ during the time period from the time that the step signal is supplied to the transmission line 2 to the time that the voltage V' at the supply point of the step signal rises because of the return of the reflected wave of the step signal reflected by a branch point to the supply point.

The capacitance calculation processing unit 22d also determines the voltage $V_{test}$ when the reflected wave of the step signal reflected by a branch point returns to the supply point of the step signal by observing the waveform of the digital signal outputted from the ADC 22c. More specifically, the capacitance calculation processing unit 22d determines the voltage $V_{test}$ during the time period from the time that the voltage V' at the supply point of the step signal rises because of the return of the reflected wave of the step signal reflected by a branch point to the supply point to the time that the voltage V' at the supply point of the step signal rises because of the return of the reflected wave of the step signal reflected by a line end to the supply point.

The capacitance calculation processing unit 22d calculates the characteristic impedance $Z_0$ of the transmission line 2 by substituting the voltage $V_0$ and the voltage $V_{test}$ into the following equation (2).

$$Z_0 = R \times \frac{V_{test}}{2 \times V_0 - V_{test}} \qquad (2)$$

In the equation (2), R denotes the resistance of a cable extending from the connection point between the step signal source 22b and the ADC 22c to the probe 25, and is, for example, 50 [$\Omega$].

Next, the capacitance calculation processing unit 22d calculates the capacitance per unit length $C_{UL}$ [F/m] of the transmission line 2 from the characteristic impedance $Z_0$, as shown in the following equation (3) (step ST8 of FIG. 4).

$$C_{UL} = \frac{\sqrt{\varepsilon_r}}{v \times Z_0} \qquad (3)$$

In the equation (3), v denotes the radio wave propagation speed [m/s], and $\varepsilon_r$ denotes the dielectric constant of the transmission line 2.

Each of the following values: the radio wave propagation speed v and the dielectric constant $\varepsilon_r$ may be stored in an internal memory of the capacitance calculation processing unit 22d, or may be provided from outside the transmission line length detection device 3.

The capacitance calculation processing unit 22d outputs the second capacitance information showing the capacitance per unit length $C_{UL}$ to the electric length calculation processing unit 23b.

The electric length calculation unit 23 acquires the first capacitance information from the capacitance calculation processing unit 21d, and acquires the second capacitance information from the capacitance calculation processing unit 22d.

The electric length calculation unit 23 calculates the electric length $E_L$ [m] of the transmission line 2 by dividing the total capacitance $C_{total}$ shown by the first capacitance information by the capacitance per unit length $C_{UL}$ shown by the second capacitance information, as shown in the following equation (4) (step ST9 of FIG. 4).

$$E_L \fallingdotseq \frac{C_{total}}{C_{UL}} \qquad (4)$$

The electric length calculation processing unit 23b outputs the display signal for causing the display unit 24 to display the electric length $E_L$ of the transmission line 2 to the display unit 24.

The display unit 24 displays the electric length $E_L$ of the transmission line 2 in accordance with the display signal outputted from the electric length calculation processing unit 23b.

When the electric length $E_L$ of the transmission line 2 is known, it is possible to determine the transmission speed [m/s] of a signal to be transmitted or received by the network communication device 1 within the range in which the communication network can be handled as a lumped constant line (refer to Embodiment 2).

In above-mentioned Embodiment 1, the transmission line length detection device 3 is configured in such a way as to include: the first capacitance calculation unit 21 to observe a voltage change in the transmission line 2 in the communication network, and to calculate the total capacitance which is the capacitance of the whole of the transmission line 2 on the basis of the voltage change; the second capacitance calculation unit 22 to measure the characteristic impedance of the transmission line 2 and to calculate the capacitance per unit length of the transmission line 2 from the characteristic impedance; and the electric length calculation unit 23 to calculate the electric length of the transmission line 2 by dividing the total capacitance calculated by the first capacitance calculation unit 21 by the capacitance per unit length calculated by the second capacitance calculation unit 22. Therefore, the transmission line length detection device 3 can measure the electric length of the transmission line 2 regardless of whether the communication network has branches in the middle of the line.

In the transmission line length detection device 3 shown in FIG. 1, after the first capacitance calculation unit 21 calculates the total capacitance $C_{total}$, the second capacitance calculation unit 22 calculates the capacitance per unit length $C_{UL}$. However, this is only an example, and the first capacitance calculation unit 21 may calculate the total capacitance $C_{total}$ after the second capacitance calculation unit 22 calculates the capacitance per unit length $C_{UL}$.

In the transmission line length detection device 3 shown in FIG. 1, the first capacitance calculation unit 21

observes a voltage change at the supply point of the constant current $I_0$ to the transmission line 2 when the constant current $I_0$ is supplied to the transmission line 2, and calculates the total capacitance $C_{total}$ of the transmission line 2 from the voltage change. However, this is only an example, and the first capacitance calculation unit 21 may observe a voltage change at the supply point of the constant current $I_0$ to the transmission line 2 when the supply of the constant current $I_0$ which has been supplied to the transmission line 2 is stopped, and calculate the total capacitance $C_{total}$ of the transmission line 2 from the voltage change.

Hereinafter, the process of calculating the total capacitance $C_{total}$ by the first capacitance calculation unit 21 will be explained concretely.

The constant current source 21b stops the supply of the constant current $I_0$ which has been supplied to the transmission line 2.

When the supply of the constant current $I_0$ which has been supplied to the transmission line 2 is stopped, the voltage reference circuit 21c observes a voltage change at the supply point of the constant current $I_0$ to the transmission line 2. When the supply of the constant current $I_0$ is stopped, the voltage V at the supply point of the constant current $I_0$ falls monotonously with time, as shown in FIG. 7. The voltage V becomes lower than the reference voltage REF [V], and, after that, becomes 0 [V].

FIG. 7 is an explanatory drawing showing the change in the voltage V at the supply point of the constant current $I_0$.

The voltage reference circuit 21c measures the time $\Delta t$ required for the voltage V at the supply point of the constant current $I_0$ to vary from the reference voltage REF [V] to 0 [V].

The voltage reference circuit 21c outputs the time $\Delta t$ to the capacitance calculation processing unit 21d.

When receiving the time $\Delta t$ from the voltage reference circuit 21c, the capacitance calculation processing unit 21d calculates the total capacitance $C_{total}$ [F] by multiplying the constant current $I_0$, which is a known value, and the time $\Delta t$ together, and dividing the result of the multiplication of the constant current $I_0$ and the time $\Delta t$ by the reference voltage REF [V], as shown in the equation (1).

In the transmission line length detection device 3 shown in FIG. 1, the second capacitance calculation unit 22 determines the characteristic impedance $Z_0$ of the transmission line 2 from the reflected wave of a step signal which, when this step signal is supplied to the transmission line 2, is reflected by either a branch point of the transmission line 2 or a line end of the transmission line 2, and which returns to the supply point of the step signal to the transmission line 2. However, this is only an example, and the second capacitance calculation unit 22 may determine the characteristic impedance $Z_0$ of the transmission line 2 from the reflected wave of a pulse signal which, when this pulse signal is supplied to the transmission line 2, is reflected by either a branch point of the transmission line 2 or a line end of the transmission line 2, and which returns to the supply point of the pulse signal to the transmission line 2. However, the second capacitance calculation unit 22 is assumed to supply a pulse signal in which the time required for its signal level to become 1 is longer than the time $\Delta t$ to the transmission line 2.

In the transmission line length detection device 3 shown in FIG. 1, the electric length calculation unit 23 calculates the electric length $E_L$ of the transmission line 2. However, the target for which the calculation of its electric length $E_L$ is performed is not limited to the transmission line 2 as long as the target has conductivity. Therefore, the electric length calculation unit 23 may calculate the electric length $E_L$ of a metallic pipe, for example.

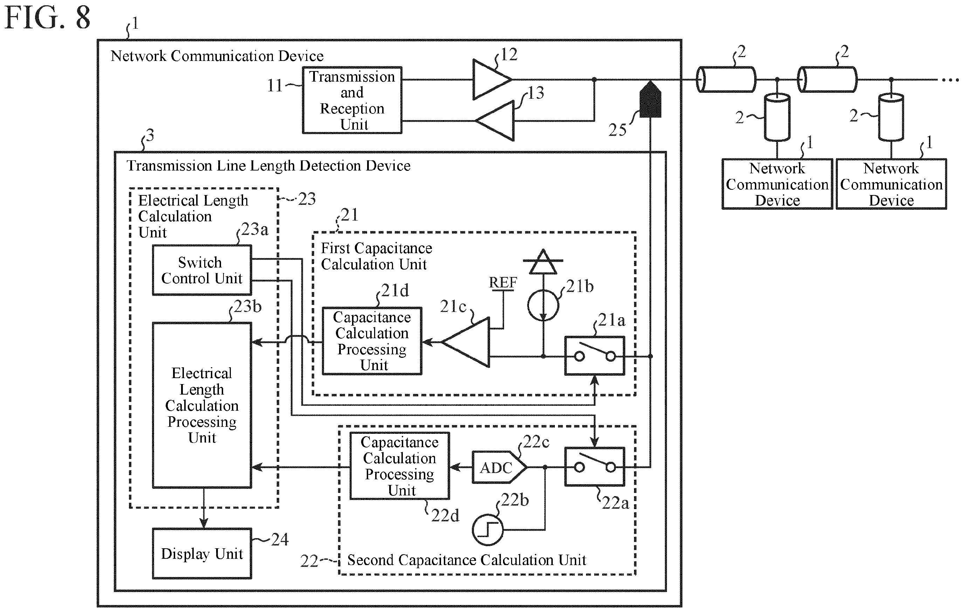

In the communication system shown in FIG. 1, each network communication device 1 and the transmission line length detection device 3 are separate. However, this is only an example, and each network communication device 1 may include the transmission line length detection device 3, as shown in FIG. 8.

FIG. 8 is a schematic diagram showing another communication system including the transmission line length detection device 3 according to Embodiment 1.

Embodiment 2.

In Embodiment 2, a transmission line length detection device 3 including an output cycle determination unit 26 to determine the output cycle of a signal to be outputted from a network communication device 1 to a transmission line 2 will be explained.

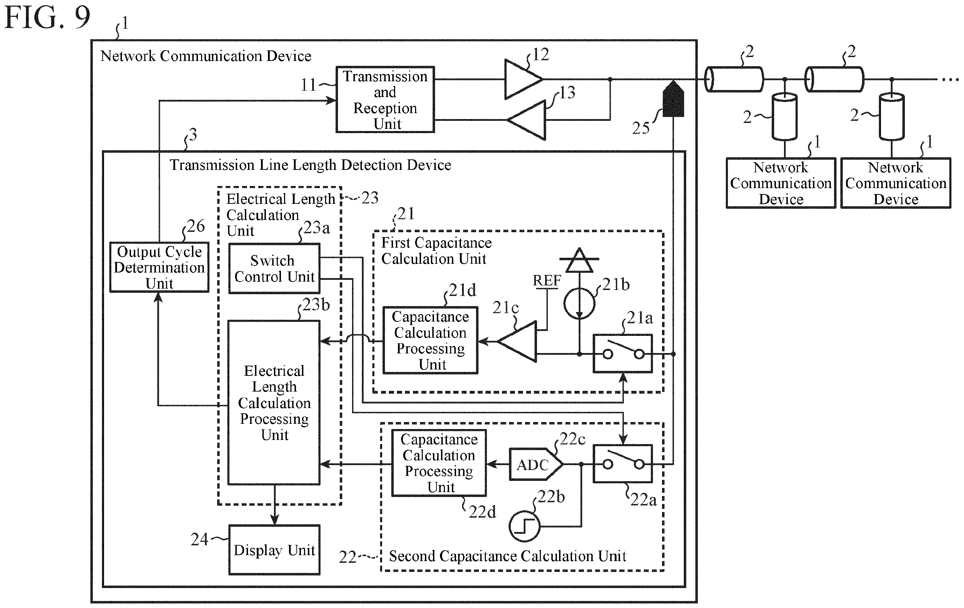

FIG. 9 is a schematic diagram showing a communication system including the transmission line length detection device 3 according to Embodiment 2. In FIG. 9, because the same reference signs as those shown in FIGS. 1 and 8 denote the same components or like components, an explanation of the components will be omitted hereinafter.

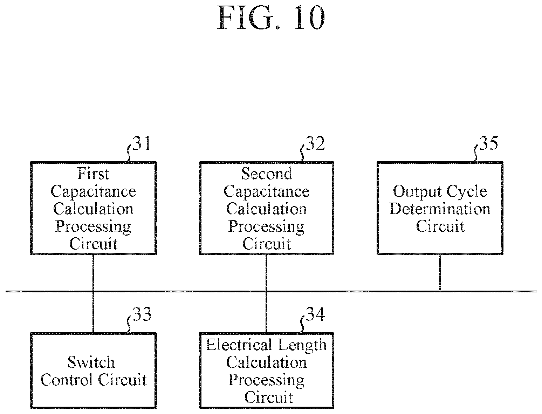

FIG. 10 is a hardware block diagram showing the hardware of a part of the transmission line length detection device 3 according to Embodiment 2. In FIG. 10, because the same reference signs as those shown in FIG. 2 denote the same components or like components, an explanation of the components will be omitted hereinafter.

The output cycle determination unit 26 is implemented by, for example, an output cycle determination circuit 35 shown in FIG. 10.

The output cycle determination unit 26 determines the output cycle of a signal to be outputted from the network communication device 1 to the transmission line 2 on the basis of an electric length $E_L$ calculated by an electric length calculation processing unit 23b of an electric length calculation unit 23.

The output cycle determination unit 26 outputs cycle information showing the determined output cycle to a transmission and reception unit 11 of the network communication device 1.

In the communication system shown in FIG. 9, the output cycle determination unit 26 is applied to the communication system shown in FIG. 8. However, this is only an example, and the output cycle determination unit 26 may be applied to the communication system shown in FIG. 1.

It is assumed in FIG. 9 that each of the following components: a capacitance calculation processing unit 21d, a capacitance calculation processing unit 22d, a switch control unit 23a, the electric length calculation processing unit 23b and the output cycle determination unit 26, which are components of the part of the transmission line length detection device 3, is implemented by hardware for exclusive use as shown in FIG. 10. More specifically, it is assumed that the part of the transmission line length detection device 3 is implemented by a first capacitance calculation processing circuit 31, a second capacitance calculation processing circuit 32, a switch control circuit 33, an electric length calculation processing circuit 34 and the output cycle determination circuit 35.

Each of the following circuits: the first capacitance calculation processing circuit 31, the second capacitance calculation processing circuit 32, the switch control circuit 33, the electric length calculation processing circuit 34 and the output cycle determination circuit 35 is, for example, a single circuit, a composite circuit, a programmable processor, a parallel programmable processor, an ASIC, an FPGA, or a combination of these circuits.

Each of the components in the part of the transmission line length detection device 3 is not limited to what is implemented by hardware for exclusive use, and the part of the transmission line length detection device 3 may be implemented by software, firmware, or a combination of software and firmware.

In the case where the part of the transmission line length detection device 3 is implemented by software, firmware or the like, a program for causing a computer to perform each of the processing procedures performed by the capacitance calculation processing unit 21d, the capacitance calculation processing unit 22d, the switch control unit 23a, the electric length calculation processing unit 23b and the output cycle determination unit 26 is stored in the memory 41 shown in FIG. 3. The processor 42 shown in FIG. 3 then executes the program stored in the memory 41.

Next, the operation of the communication system shown in FIG. 9 will be explained. However, because the communication system is the same as that shown in FIG. 1 or 8, except for the output cycle determination unit 26, the operation of the output cycle determination unit 26 will be mainly explained hereinafter.

When calculating the electric length $E_L$ of the transmission line 2, the electric length calculation processing unit 23b outputs information showing the electric length $E_L$ to the output cycle determination unit 26.

When receiving the information showing the electric length $E_L$ from the electric length calculation processing unit 23b, the output cycle determination unit 26 substitutes the electric length $E_L$ into the following equation (5), and calculates a minimum wavelength $\lambda$ for which the equation (5) holds. $\lambda$ denotes the wavelength of the signal v to be outputted from the network communication device 1 to the transmission line 2.

In the transmission line length detection device 3 shown in FIG. 9, the output cycle determination unit 26 calculates the minimum wavelength $\lambda$ for which the equation (5) holds. However, the calculated wavelength is not limited to the minimum wavelength $\lambda$ as long as it is a wavelength $\lambda$ for which the equation (5) holds, the output cycle determination unit 26 may calculate a wavelength longer, by several percent, than the minimum wavelength $\lambda$, for example.

$$\frac{\lambda}{20 \times \sqrt{\varepsilon_r}} > E_L \qquad (5)$$

Next, the output cycle determination unit 26 calculates the frequency f of the signal to be outputted from the network communication device 1 to the transmission line 2 by substituting the wavelength $\lambda$ into the following equation (6).

$$f = \frac{v}{\lambda} \qquad (6)$$

When calculating the frequency f of the signal, the output cycle determination unit 26 calculates the output cycle T of the signal to be outputted from the network communication device 1 to the transmission line 2 by substituting the frequency f into the following equation (7).

$$T = \frac{1}{f} \qquad (7)$$

The output cycle determination unit 26 outputs cycle information showing the output cycle T of the signal to the transmission and reception unit 11 of the network communication device 1.

When receiving the cycle information from the output cycle determination unit 26, the transmission and reception unit 11 of the network communication device 1 sets the output cycle of a transmission signal to be outputted to the transmission line 2 via a driver IC 12 to the output cycle T shown by the cycle information. The setting of the output cycle of the transmission signal corresponds to the setting of the transmission speed of the transmission signal.

After that, the transmission and reception unit 11 outputs the transmission signal, via the driver IC 12, to the transmission line 2 in the set output cycle T. For example, when the transmission signal is "101", the transmission and reception unit 11 transmits "0" when the output cycle T has elapsed after transmitting " 1", and then transmits " 1" when the output cycle T has elapsed after transmitting "0."

In above-mentioned Embodiment 2, the transmission line length detection device 3 is configured in such a way as to include the output cycle determination unit 26 to determine the output cycle of a signal to be outputted from a network communication device 1 connected to the transmission line 2 to the transmission line 2 on the basis of the electric length calculated by the electric length calculation unit 23. Therefore, the transmission line length detection device 3 can measure the electric length of the transmission line 2 regardless of whether the communication network has branches in the middle of the line, and can also determine the transmission speed of a signal to be outputted from the network communication device 1 in such a way that the transmission speed falls within the range in which the communication network can be handled as a lumped constant line.

Embodiment 3.

In Embodiment 3, a transmission line length detection device 3 including an abnormality detection unit 27 to detect either a wiring abnormality in a transmission line 2 or an unauthorized connection to the transmission line 2 will be explained.

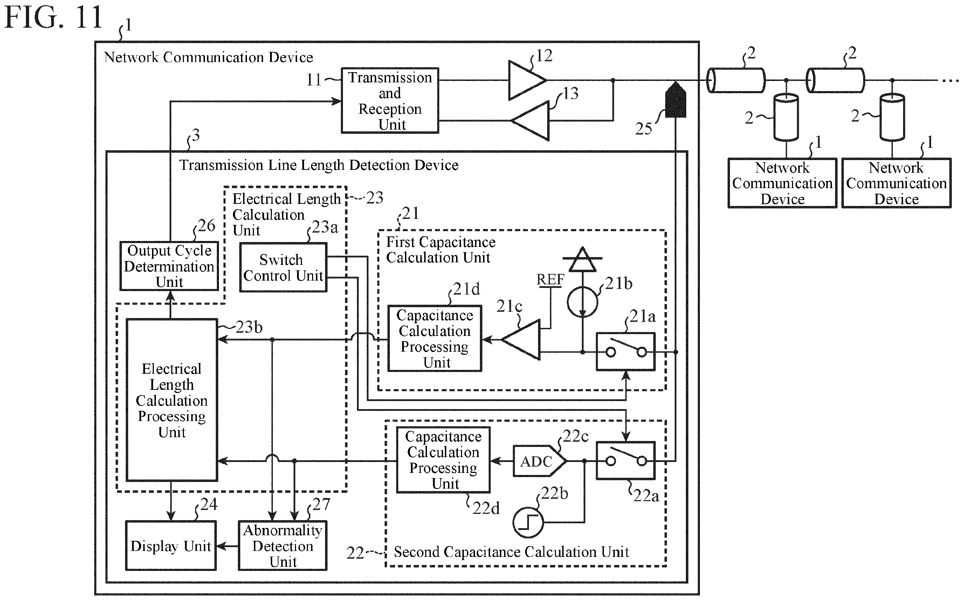

FIG. 11 is a schematic diagram showing a communication system including the transmission line length detection device 3 according to Embodiment 3. In FIG. 11, because the same reference signs as those shown in FIGS. 1, 8 and 9 denote the same components or like components, an explanation of the components will be omitted hereinafter.

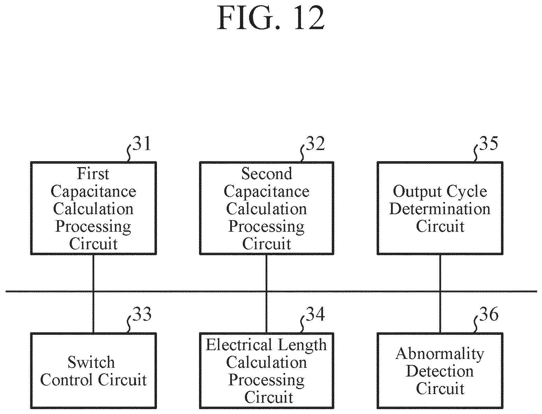

FIG. 12 is a hardware block diagram showing the hardware of a part of the transmission line length detection device 3 according to Embodiment 3. In FIG. 12, because the same reference signs as those shown in FIGS. 2 and 10 denote the same components or like components, an explanation of the components will be omitted hereinafter.

The abnormality detection unit 27 is implemented by, for example, an abnormality detection circuit 36 shown in FIG. 10.

The abnormality detection unit 27 acquires a total capacitance $C_{total}$ calculated by a first capacitance calculation unit 21, a characteristic impedance $Z_0$ measured by a second capacitance calculation unit 22, and a capacitance per unit length $C_{UL}$ calculated by the second capacitance calculation unit 22.

The abnormality detection unit 27 detects either a wiring abnormality of the transmission line 2 or an unauthorized connection to the transmission line 2 from the total capacitance $C_{total}$, the characteristic impedance $Z_0$ and the capacitance per unit length $C_{UL}$.

As a wiring abnormality of the transmission line 2, there is a disconnection or electrical short of the transmission line 2, or the like. As an unauthorized connection to the transmission line 2, there is a case in which a computer, a communication device or the like is connected to the transmission line 2 in an unauthorized way.

It is assumed in the communication system shown in FIG. 11 that in the beginning when an electric length $E_L$ is calculated by an electric length calculation unit 23, there is no wiring abnormality of the transmission line 2. The abnormality detection unit 27 detects a wiring abnormality or the like which has occurred after that.

In the communication system shown in FIG. 11, the abnormality detection unit 27 is applied to the communication system shown in FIG. 9. However, this is only an example, and the abnormality detection unit 27 may be applied to the communication system shown in FIG. 1 or 8.

It is assumed in FIG. 11 that each of the following components: a capacitance calculation processing unit 21d, a capacitance calculation processing unit 22d, a switch control unit 23a, an electric length calculation processing unit 23b, an output cycle determination unit 26 and the abnormality detection unit 27, which are components of the part of the transmission line length detection device 3, is implemented by hardware for exclusive use as shown in FIG. 12. More specifically, it is assumed that the part of the transmission line length detection device 3 is implemented by a first capacitance calculation processing circuit 31, a second capacitance calculation processing circuit 32, a switch control circuit 33, an electric length calculation processing circuit 34, an output cycle determination circuit 35 and an abnormality detection circuit 36.

Each of the following circuits: the first capacitance calculation processing circuit 31, the second capacitance calculation processing circuit 32, the switch control circuit 33, the electric length calculation processing circuit 34, the output cycle determination circuit 35 and the abnormality detection circuit 36 is, for example, a single circuit, a composite circuit, a programmable processor, a parallel programmable processor, an ASIC, an FPGA, or a combination of these circuits.

Each of the components in the part of the transmission line length detection device 3 is not limited to what is implemented by hardware for exclusive use, and the part of the transmission line length detection device 3 may be implemented by software, firmware, or a combination of software and firmware.

In the case where the part of the transmission line length detection device 3 is implemented by software, firmware or the like, a program for causing a computer to perform each of the processing procedures performed by the capacitance calculation processing unit 21d, the capacitance calculation processing unit 22d, the switch control unit 23a, the electric length calculation processing unit 23b, the output cycle determination unit 26 and the abnormality detection unit 27 is stored in the memory 41 shown in FIG. 3. The processor 42 shown in FIG. 3 then executes the program stored in the memory 41.

Next, the operation of the communication system shown in FIG. 11 will be explained. However, because the communication system is the same as that shown in FIG. 1, 8 or 9, except for the abnormality detection unit 27, the operation of the abnormality detection unit 27 will be mainly explained hereinafter.

The abnormality detection unit 27 acquires the total capacitance $C_{total}$ calculated by the first capacitance calculation unit 21, the characteristic impedance $Z_0$ measured by the second capacitance calculation unit 22, and the capacitance per unit length $C_{UL}$ calculated by the second capacitance calculation unit 22.

The abnormality detection unit 27 stores the total capacitance $C_{total}$ as an initial total capacitance $C_{total}'$ in an internal memory, and stores the characteristic impedance $Z_0$ as an initial characteristic impedance $Z_0'$ in the internal memory.

The abnormality detection unit 27 also stores the capacitance per unit length $C_{UL}$ as an initial capacitance $C_{UL}'$ in the internal memory.

After that, the abnormality detection unit 27 repeatedly acquires the total capacitance $C_{total}$ newly calculated by the first capacitance calculation unit 21, the characteristic impedance $Z_0$ newly measured by the second capacitance calculation unit 22, and the capacitance per unit length $C_{UL}$ newly calculated by the second capacitance calculation unit 22.

Every time when acquiring the total capacitance $C_{total}$, the characteristic impedance $Z_0$ and the capacitance per unit length $C_{UL}$, the abnormality detection unit 27 calculates the difference $\Delta C_{total}$ between the acquired total capacitance $C_{total}$ and the initial total capacitance $C_{total}'$.

The abnormality detection unit 27 also calculates the difference $\Delta Z_0$ between the acquired characteristic impedance $Z_0$ and the initial characteristic impedance $Z_0'$, and the difference $\Delta C_{UL}$ between the acquired capacitance per unit length $C_{UL}$ and the initial capacitance $C_{UL}'$.

The abnormality detection unit 27 compares the difference $\Delta C_{total}$ and a first threshold Thi, and determines that there is either a wiring abnormality of the transmission line 2 or an unauthorized connection to the transmission line 2 when the difference $\Delta C_{total}$ is greater than the first threshold $Th_1$.

The abnormality detection unit 27 compares the difference $\Delta Z_0$ and a second threshold $Th_2$, and determines that there is either a wiring abnormality of the transmission line 2 or an unauthorized connection to the transmission line 2 when the difference $\Delta Z_0$ is greater than the second threshold $Th_2$.

The abnormality detection unit 27 compares the difference $\Delta C_{UL}$ and a third threshold $Th_3$, and determines that there is either a wiring abnormality of the transmission line 2 or an unauthorized connection to the transmission line 2 when the difference $\Delta C_{UL}$ is greater than the third threshold $Th_3$.

When the difference $\Delta C_{total}$ is equal to or less than the first threshold $Th_1$, the difference $\Delta Z_0$ is equal to or less than the second threshold $Th_2$, and the difference $\Delta C_{UL}$ is equal to or less than the third threshold $Th_3$, the abnormality detection unit 27 determines that there is neither a wiring abnormality of the transmission line 2 nor an unauthorized connection to the transmission line 2.

Each of the first, second and third thresholds $Th_1$, $Th_2$ and $Th_3$ may be stored in the internal memory of the abnormality detection unit 27, or may be provided from outside the transmission line length detection device 3.

When determining that there is either a wiring abnormality of the transmission line 2 or an unauthorized connection to the transmission line 2, the abnormality detection unit 27 causes a display unit 24 to display a determination result to that effect.

When determining that there is neither a wiring abnormality of the transmission line 2 nor an unauthorized connection to the transmission line 2, the abnormality detection unit 27 causes the display unit 24 to display a determination result to that effect.

In above-mentioned Embodiment 3, the transmission line length detection device 3 is configured in such a way as to include the abnormality detection unit 27 to detect either a wiring abnormality of the transmission line 2 or an unauthorized connection to the transmission line 2 from the total capacitance calculated by the first capacitance calculation unit 21, the characteristic impedance measured by the second capacitance calculation unit 22, and the capacitance per unit length calculated by the second capacitance calculation unit 22. Therefore, the transmission line length detection device 3 can measure the electric length of the transmission line 2 regardless of whether a communication network has branches in the middle of the line, and can also detect either a wiring abnormality of the transmission line 2 or an unauthorized connection to the transmission line 2.

In the communication systems according to Embodiments 1 to 3, the second capacitance calculation unit 22 includes the step signal source 22b to supply a step signal to the transmission line 2. However, this is only an example, and the second capacitance calculation unit 22 may acquire a data pattern which is an imitation of a step signal from the transmission and reception unit 11 of a network communication device 1, and supply a signal showing the data pattern, as a step signal, to the transmission line 2. The data pattern which is an imitation of a step signal is, for example, 0111⋯⋯.

It is to be understood that an arbitrary combination of two or more of the above-mentioned embodiments can be made, various changes can be made in an arbitrary component according to any one of the above-mentioned embodiments, or an arbitrary component according to any one of the above-mentioned embodiments can be omitted within the scope of the present disclosure.

## INDUSTRIAL APPLICABILITY

The present disclosure is suitable for a transmission line length detection device that calculates the electric length of a transmission line.

Further, the present disclosure is suitable for a network communication device that includes the transmission line length detection device.

## REFERENCE SIGNS LIST

1: Network communication device, 2: Transmission line, 3: Transmission line length detection device, 11: Transmission and reception unit, 12: Driver IC, 13: Receiver IC, 21: First capacitance calculation unit, 21a: Switch, 21b: Constant current source, 21c: Voltage reference circuit, 21d: Capacitance calculation processing unit, 22: Second capacitance calculation unit, 22a: Switch, 22b: Step signal source, 22c: ADC, 22d: Capacitance calculation processing unit, 23: Electric length calculation unit, 23a: Switch control unit, 23b: Electric length calculation processing unit, 24: Display unit, 25: Probe, 26: Output cycle determination unit, 27: Abnormality detection unit, 31: First capacitance calculation processing circuit, 32: Second capacitance calculation Processing circuit, 33: Switch control circuit, 34: Electric length calculation processing circuit, 35: Output cycle determination circuit, 36: Abnormality detection circuit, 41: Memory, and 42: Processor.

## Claims

1. A transmission line length detection device (3) comprising:

   a first capacitance calculation unit (21) to observe a voltage change in a transmission line (2) in a communication network, and to calculate total capacitance which is capacitance of a whole of the transmission line (2) on a basis of the voltage change;
   a second capacitance calculation unit (22) to measure a characteristic impedance of the transmission line (2) and to calculate a capacitance per unit length of the transmission line (2) from the characteristic impedance; and
   an electric length calculation unit (23) to calculate an electric length of the transmission line (2) by dividing the total capacitance calculated by the first capacitance calculation unit (21) by the capacitance per unit length calculated by the second capacitance calculation unit (22).

2. The transmission line length detection device (3) according to claim 1, wherein the transmission line length detection device (3) comprises an output cycle determination unit (26) to determine an output cycle of a signal to be outputted from a network communication device connected to the transmission line (2) to the transmission line (2) on a basis of the electric length calculated by the electric length calculation unit (23).

3. The transmission line length detection device (3) according to claim 1 or claim 2, wherein the transmission line length detection device (3) comprises an abnormality detection unit (27) to detect either a wiring abnormality in the transmission line (2) or an unauthorized connection to the transmission line (2), from the total capacitance calculated by the first capacitance calculation unit (21), the characteristic impedance measured by the second capacitance calculation unit (22), and the capacitance per unit length calculated by the second capacitance calculation unit (22).

4. The transmission line length detection device (3) according to any one of claims 1 to 3, wherein the first capacitance calculation unit (21) observes a voltage change at a supply point of a constant current to the transmission line (2) when the constant current is supplied to the transmission line (2), and calculates the total capacitance of the transmission line (2) from the voltage change.

5. The transmission line length detection device (3) according to any one of claims 1 to 3, wherein the first capacitance calculation unit (21) observes a voltage change at a supply point of a constant current to the transmission line (2) when the supply of the constant current to the transmission line (2) is stopped, and calculates the total capacitance of the transmission line (2) from the voltage change.

6. The transmission line length detection device (3) according to any one of claims 1 to 5, wherein the second capacitance calculation unit (22) determines the characteristic impedance of the transmission line (2) from a reflected wave of a step signal which, when this step signal is supplied to the transmission line (2), is reflected by either a branch point of the transmission line (2) or a line end of the transmission line (2), and which returns to a supply point of the step signal to the transmission line (2), and calculates the capacitance per unit length of the transmission line (2) from the characteristic impedance.

7. The transmission line length detection device (3) according to claim 6, wherein the second capacitance calculation unit (22) includes a step signal source (22b) to supply the step signal to the transmission line (2).

8. A network communication device (1) comprising:

a transmission and reception unit (11) to output a signal to the transmission line (2), and to also receive a signal transmitted through a transmission line (2) of a communication network; and
a transmission line length detection device (3) to calculate an electric length of the transmission line (2),
wherein the transmission line length detection device (3) is the one according to any one of claims 1 to 7.


**Patentansprüche**

1. Übertragungsleitungslänge-Erfassungseinrichtung (3), umfassend:

eine Erste-Kapazität-Berechnungseinheit (21), um eine Spannungsänderung in einer Übertragungsleitung (2) in einem Kommunikationsnetz zu beobachten, und die Gesamtkapazität, welche eine Kapazität der gesamten Übertragungsleitung (2) ist, auf der Grundlage der Spannungsänderung zu berechnen;
eine Zweite-Kapazität-Berechnungseinheit (22), um eine charakteristische Impedanz der Übertragungsleitung (2) zu messen, und eine Kapazität pro Längeneinheit der Übertragungsleitung (2) aus der charakteristischen Impedanz zu berechnen; und
eine Elektrische-Länge-Berechnungseinheit (23), um eine elektrische Länge der Übertragungsleitung (2) durch Dividieren der von der Erste-Kapazität-Berechnungseinheit (21) berechneten Gesamtkapazität durch die von der Zweite-Kapazität-Berechnungseinheit (22) berechnete Kapazität pro Längeneinheit zu berechnen.

2. Übertragungsleitungslänge-Erfassungseinrichtung (3) nach Anspruch 1, wobei die Übertragungsleitungslänge-Erfassungseinrichtung (3) eine Ausgabezyklus-Bestimmungseinheit (26) umfasst, um einen Ausgabezyklus eines Signals zu bestimmen, das von einer Netzkommunikationseinrichtung, die mit der Übertragungsleitung (2) verbunden ist, an die Übertragungsleitung (2) auszugeben ist, auf der Grundlage der von der Elektrische-Länge-Berechnungseinheit (23) berechneten elektrischen Länge.

3. Übertragungsleitungslänge-Erfassungseinrichtung (3) nach Anspruch 1 oder Anspruch 2, wobei die Übertragungsleitungslänge-Erfassungseinrichtung (3) eine Anomalie-Erfassungseinheit (27) umfasst, um entweder eine Verdrahtungsanomalie in der Übertragungsleitung (2) oder eine nicht autorisierte Verbindung mit der Übertragungsleitung (2) aus der Gesamtkapazität, die durch die Erste-Kapazität-Berechnungseinheit (21) berechnet wird, der charakteristischen Impedanz, die durch die Zweite-Kapazität-Berechnungseinheit (22) gemessen wird, und der Kapazität pro Längeneinheit, die durch die Zweite-Kapazität-Berechnungseinheit (22) berechnet wird, zu erfassen.

4. Übertragungsleitungslänge-Erfassungseinrichtung (3) nach einem der Ansprüche 1 bis 3, wobei die Erste-Kapazität-Berechnungseinheit (21) eine Spannungsänderung an einem Zuführpunkt eines konstanten Stroms an die Übertragungsleitung (2) beobachtet, wenn der konstante Strom der Übertragungsleitung (2) zugeführt wird, und die Gesamtkapazität der Übertragungsleitung (2) aus der Spannungsänderung berechnet.

5. Übertragungsleitungslänge-Erfassungseinrichtung (3) nach einem der Ansprüche 1 bis 3, wobei die Erste-Kapazität-Berechnungseinheit (21) eine Spannungsänderung an einem Zuführpunkt eines konstanten Stroms an die Übertragungsleitung (2) beobachtet, wenn die Zuführung des konstanten Stroms an die Übertragungsleitung (2) gestoppt wird, und die Gesamtkapazität der Übertragungsleitung (2) aus der Spannungsänderung berechnet.

6. Übertragungsleitungslänge-Erfassungseinrichtung (3) nach einem der Ansprüche 1 bis 5, wobei die Zweite-Kapazität-Berechnungseinheit (22) die charakteristische Impedanz der Übertragungsleitung (2) aus einer reflektierten Welle eines Stufensignals bestimmt, welche, wenn dieses Stufensignal an die Übertragungsleitung (2) abgegeben wird, entweder von einem Verzweigungspunkt der Übertragungsleitung (2) oder einem Leitungsende der Übertragungsleitung (2) reflektiert wird, und welche zu einem Zuführungspunkt des Stufensignals zu der Übertragungsleitung (2) zurückkehrt, und die Kapazität pro Längeneinheit der Übertragungsleitung (2) aus der charakteristischen Impedanz berechnet.

7. Übertragungsleitungslänge-Erfassungseinrichtung (3) nach Anspruch 6, wobei die Zweite-Kapazität-Berechnungseinheit (22) eine Stufensignalquelle (22b) aufweist, um das Stufensignal an die Übertragungsleitung (2) abzugeben.

8. Netzkommunikationseinrichtung (1), umfassend:

   eine Übertragungs- und Empfangseinheit (11), um ein Signal an die Übertragungsleitung (2) auszugeben, und außerdem ein Signal zu empfangen, das über eine Übertragungsleitung (2) eines Kommunikationsnetzes übertragen wurde; und
   eine Übertragungsleitungslänge-Erfassungseinrichtung (3), um eine elektrische Länge der Übertragungsleitung (2) zu berechnen,
   wobei die Übertragungsleitungslänge-Erfassungseinrichtung (3) die eine nach einem der Ansprüche 1 bis 7 ist.

## Revendications

1. Dispositif de détection de longueur de ligne de transmission (3) comprenant :

   une première unité de calcul de capacité (21) pour observer un changement de tension dans une ligne de transmission (2) dans un réseau de communication, et pour calculer la capacité totale qui est la capacité d'un ensemble de la ligne de transmission (2) sur la base du changement de tension ;
   une seconde unité de calcul de capacité (22) pour mesurer une impédance caractéristique de la ligne de transmission (2) et pour calculer une capacité par unité de longueur de la ligne de transmission (2) à partir de l'impédance caractéristique ; et
   une unité de calcul de longueur électrique (23) pour calculer une longueur électrique de la ligne de transmission (2) en divisant la capacité totale calculée par la première unité de calcul de capacité (21) par la capacité par unité de longueur calculée par la seconde unité de calcul de capacité (22).

2. Dispositif de détection de longueur de ligne de transmission (3) selon la revendication 1, dans lequel le dispositif de détection de longueur de ligne de transmission (3) comprend une unité de détermination de cycle de sortie (26) pour déterminer un cycle de sortie d'un signal à émettre à partir d'un dispositif de communication de réseau connecté à la ligne de transmission (2) vers la ligne de transmission (2) sur la base de la longueur électrique calculée par l'unité de calcul de longueur électrique (23).

3. Dispositif de détection de longueur de ligne de transmission (3) selon la revendication 1 ou la revendication 2, dans lequel le dispositif de détection de longueur de ligne de transmission (3) comprend une unité de détection d'anomalie (27) pour détecter soit une anomalie de câblage dans la ligne de transmission (2), soit une connexion non autorisée à la ligne de transmission (2), à partir de la capacité totale calculée par la première unité de calcul de capacité (21), de l'impédance caractéristique mesurée par la seconde unité de calcul de capacité (22), et de la capacité par unité de longueur calculée par la seconde unité de calcul de capacité (22).

4. Dispositif de détection de longueur de ligne de transmission (3) selon l'une quelconque des revendications 1 à 3, dans lequel la première unité de calcul de capacité (21) observe un changement de tension à un point d'alimentation en un courant constant de la ligne de transmission (2) lorsque le courant constant est fourni à la ligne de transmission (2), et calcule la capacité totale de la ligne de transmission (2) à partir du changement de tension.

**5.** Dispositif de détection de longueur de ligne de transmission (3) selon l'une quelconque des revendications 1 à 3, dans lequel la première unité de calcul de capacité (21) observe un changement de tension à un point d'alimentation en un courant constant de la ligne de transmission (2) lorsque l'alimentation en courant constant de la ligne de transmission (2) est arrêtée, et calcule la capacité totale de la ligne de transmission (2) à partir du changement de tension.

**6.** Dispositif de détection de longueur de ligne de transmission (3) selon l'une quelconque des revendications 1 à 5, dans lequel la seconde unité de calcul de capacité (22) détermine l'impédance caractéristique de la ligne de transmission (2) à partir d'une onde réfléchie d'un signal en échelon qui, lorsque ce signal en échelon est fourni à la ligne de transmission (2), est réfléchie par un point de dérivation de la ligne de transmission (2) ou par une extrémité de ligne de la ligne de transmission (2), et qui revient à un point d'alimentation du signal en échelon vers la ligne de transmission (2), et calcule la capacité par unité de longueur de la ligne de transmission (2) à partir de l'impédance caractéristique.

**7.** Dispositif de détection de longueur de ligne de transmission (3) selon la revendication 6, dans lequel la seconde unité de calcul de capacité (22) comprend une source de signal en échelon (22b) pour fournir le signal en échelon à la ligne de transmission (2).

**8.** Dispositif de communication de réseau (1) comprenant :

une unité de transmission et de réception (11) pour émettre un signal vers la ligne de transmission (2) et pour recevoir également un signal transmis par une ligne de transmission (2) d'un réseau de communication ; et
un dispositif de détection de longueur de ligne de transmission (3) pour calculer une longueur électrique de la ligne de transmission (2),
dans lequel le dispositif de détection de longueur de ligne de transmission (3) est celui selon l'une quelconque des revendications 1 à 7.

FIG. 1

Network Communication Device — 1

Transmission and Reception Unit — 11

12
13
25

Network Communication Device — 1
Network Communication Device — 1

2
2
2
2

Transmission Line Length Detection Device — 3

First Capacitance Calculation Unit — 21
21a
21b
21c
21d
REF
Capacitance Calculation Processing Unit

Second Capacitance Calculation Unit — 22
22a
22b
22c — ADC
22d
Capacitance Calculation Processing Unit

Electrical Length Calculation Unit — 23
Switch Control Unit — 23a
23b
Electrical Length Calculation Processing Unit

Display Unit — 24

# FIG. 2

|     |     |
| --- | --- |
| ⌐31<br>First<br>Capacitance<br>Calculation<br>Processing<br>Circuit | ⌐32<br>Second<br>Capacitance<br>Calculation<br>Processing<br>Circuit |
| ⌐33<br>Switch<br>Control Circuit | ⌐34<br>Electrical Length<br>Calculation<br>Processing<br>Circuit |

# FIG. 3

|     |     |
| --- | --- |
| ⌐41<br>Memory | ⌐42<br>Processor |

# FIG. 4

START

Switch Control Unit 23a Places
Switch 21a in Closed State,
and Places Switch 22a in
Open State ——ST1

Constant Current Source 21b
Supplies Constant Current to
Transmission Line ——ST2

Voltage Reference Circuit 21c
Measures Time $\Delta t$ ——ST3

Capacitance Calculation
Processing Unit 21d Calculates
Total Capacitance ——ST4

Switch Control Unit 23a Places
Switch 21a in Open State,
and Places Switch 22a in
Closed State ——ST5

Step Signal Source 22b Supplies
Step Signal to Transmission Line ——ST6

Capacitance Calculation
Processing Unit 22d Determines
Characteristic Impedance ——ST7

Capacitance Calculation
Processing Unit 22d Calculates
Capacitance per Unit Length ——ST8

Electrical Length
Calculation Unit 23 Calculates
Electrical Length
of Transmission Line ——ST9

END

FIG. 5

FIG. 6

FIG. 7

FIG. 8

# FIG. 9

EP 4 119 955 B1

# FIG. 10

```
       ┌31              ┌32              ┌35
┌──────────────┐ ┌──────────────┐ ┌──────────────┐
│    First     │ │    Second    │ │              │
│  Capacitance │ │  Capacitance │ │ Output Cycle │
│  Calculation │ │  Calculation │ │ Determination│
│  Processing  │ │  Processing  │ │   Circuit    │
│    Circuit   │ │    Circuit   │ │              │
└──────┬───────┘ └──────┬───────┘ └──────┬───────┘
       │                │                │
───────┼────────────────┼────────────────┼───────
       │                │
     ┌33              ┌34
┌──────────────┐ ┌──────────────┐
│              │ │Electrical Length│
│    Switch    │ │  Calculation │
│Control Circuit│ │  Processing  │
│              │ │    Circuit   │
└──────────────┘ └──────────────┘
```

# FIG. 11

EP 4 119 955 B1

# FIG. 12

| First Capacitance Calculation Processing Circuit ⌐31 | Second Capacitance Calculation Processing Circuit ⌐32 | Output Cycle Determination Circuit ⌐35 |

| Switch Control Circuit ⌐33 | Electrical Length Calculation Processing Circuit ⌐34 | Abnormality Detection Circuit ⌐36 |

**REFERENCES CITED IN THE DESCRIPTION**

**Patent documents cited in the description**

- JP 2013024729 A

- US 20170146332 A1